# EUROPEAN PATENT APPLICATION

(11) **EP 1 615 259 A1**
(43) Date of publication of application: **11.01.2006**
(21) Application number: 04720191.8
(22) Date of filing: 12.03.2004
(51) Int. Cl.: H01L 21/205

(54) **SUSCEPTOR AND VAPOR GROWTH DEVICE**

(30) Priority: 14.04.2003 JP 2003109063
(71) Applicant: Shin-Etsu Handotai Co., Ltd, Tokyo 100-0005 (JP)
(72) Inventor: KANAYA, K. Shin-Etsu Handotai Co. Ltd. Shirakawa, Nishishirakawa-gun, Fukushima961-8061 (JP); OTSUKA, T. Shin-Etsu Handotai Co., Ltd., Shirakawa, Nishishirakawa-gun, Fukushima 961-8061 (JP); OSE, Hiroki Shin-Etsu Handotai Co. Ltd. Isobe, Annaka-shi, Gunma 379-0196 (JP)
(74) Representative: Jones, Helen M.M.
(86) International application number: PCT/JP2004/003338
(87) International publication number: WO 2004/093173

(57) **Abstract**

A susceptor (2) in which a semiconductor substrate (W) is supported approximately horizontally in a pocket (2c) when performing a vapor phase growth of a single crystal thin film on a front surface of the semiconductor substrate (W), and in which the pocket (2c) comprises an outer peripheral pocket portion (20) to support the semiconductor substrate (W) and a central side pocket portion (21) which is formed inside the outer peripheral side pocket portion (20) to be concave from the outer peripheral side pocket portion (20), wherein the outer peripheral side pocket portion (20) comprises a substrate supporting surface (20a) which is inclined with respect to a horizontal surface to be lowered toward a central side from an outer peripheral side of the pocket (2c), and a region of the substrate supporting surface (20a) excluding at least an inner peripheral edge supports a portion of a rear surface of the semiconductor substrate (W) which is inside an outer peripheral edge of the semiconductor substrate (W).

## Description

### Field of the Invention

The present invention relates to a susceptor on which a semiconductor substrate is placed, and a vapor phase growth apparatus having the susceptor.

### Background Art

Conventionally, as an apparatus to perform vapor phase growth of a single crystal thin film on a front surface of a semiconductor substrate, a so-called single wafer type vapor phase growth apparatus has been known. The single wafer type vapor phase growth apparatus comprises a susceptor having an approximately disk shape to support the semiconductor substrate, and is configured to perform vapor phase growth of a single crystal thin film by supplying a reaction gas onto the front surface while heating the semiconductor substrate on the susceptor from both sides.

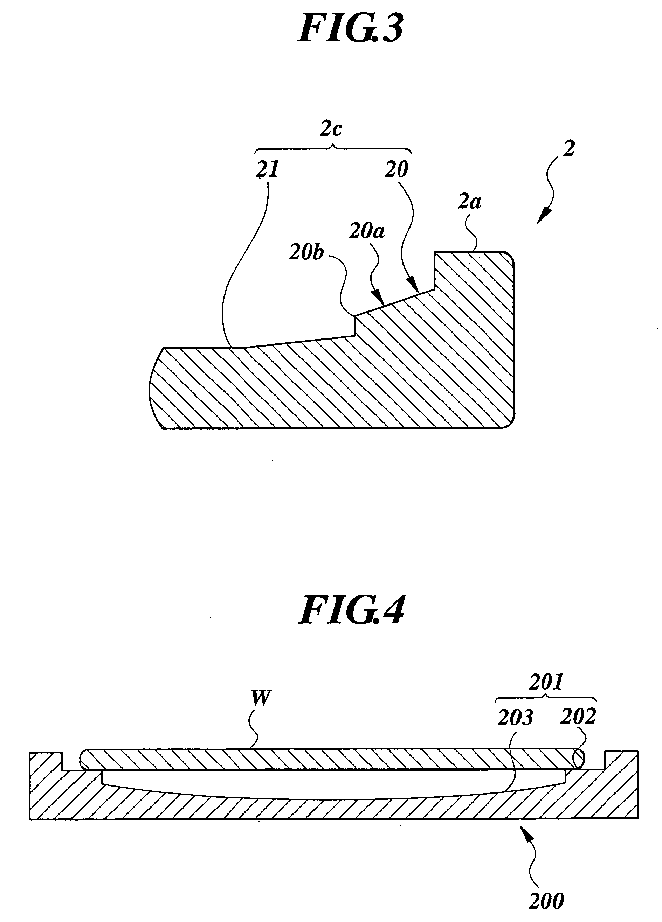

More particularly, as shown in FIG. 4, a susceptor 200 comprises a pocket 201 at a central portion of the front surface, and a semiconductor substrate W is supported within the pocket 201. The pocket 201 comprises an outer peripheral side pocket portion 202 having a flat and annular shaped substrate supporting surface and a central side pocket portion 203 which is formed to be concave from the outer peripheral side pocket 202 (for example, refer to JP-Tokukaisyo-61-215289A).

However, when the semiconductor substrate W is placed within the pocket 201, an arc shaped scratch tends to be generated at a portion at which the semiconductor substrate W contacts the outer peripheral pocket portion 202.

The present invention is achieved to solve the above problem, and an object is to provide a susceptor and a vapor phase growth apparatus which can suppress generation of a scratch.

### Disclosure of The Invention

In accordance with the first aspect of the present invention, the susceptor of the present invention in which a semiconductor substrate is supported approximately horizontally in a pocket when performing a vapor phase growth of a single crystal thin film on a front surface of the semiconductor substrate, and in which the pocket comprises an outer peripheral pocket portion to support the semiconductor substrate and a central side pocket portion which is formed inside the outer peripheral side pocket portion to be concave from the outer peripheral side pocket portion,
wherein the outer peripheral side pocket portion comprises a substrate supporting surface which is inclined with respect to a horizontal surface to be lowered toward a central side from an outer peripheral side of the pocket, and a region of the substrate supporting surface excluding at least an inner peripheral edge supports a portion of a rear surface of the semiconductor substrate which is inside an outer peripheral edge of the semiconductor substrate.

The inventors have made diligent studies to solve the above problem. As a result, it has been found that an arc shaped scratch is generated on a rear surface of a semiconductor substrate, because a semiconductor substrate warps to be in a U shape in longitudinal sectional view due to heat stress and therefore the rear surface of the semiconductor substrate is supported by an inner peripheral edge of a substrate supporting surface of a pocket, that is, a corner portion formed between an outer peripheral side pocket portion and a central side pocket portion.

Even in a case that the substrate supporting surface is inclined toward the inner peripheral side from the outer peripheral side of the pocket, when the inclination angle with respect to a horizontal surface is too large, the substrate supporting surface supports the semiconductor substrate only at the outer peripheral edge of the semiconductor substrate. Therefore, although the semiconductor substrate does not have a scratch on its rear surface, frequency of occurrence of slip dislocation of the single crystal thin film which is subjected to vapor phase growth increases rapidly. Specifically, for example, in a case of a pocket for a silicon single crystal substrate of 300mm in diameter, when the inclination angle of the substrate supporting surface with respect to the horizontal surface is larger than 1 degree, frequency of occurrence of slip dislocation of the single crystal thin film which is subjected to vapor phase growth increases rapidly.

On the other hand, when the inclination angle of the substrate supporting surface with respect to the horizontal surface is 0 degree or less, that is, when the substrate supporting surface is flat or inclined to become high toward the central side from the outer peripheral side of the pocket, the inner peripheral edge of the substrate supporting surface contacts the rear surface of the semiconductor substrate, consequently making an arc shaped scratch prone to be generated on the rear surface of the semiconductor substrate. In a case where the inclination angle of the substrate supporting surface with respect to the peripheral surface of the pocket on the front surface of the susceptor (hereinafter, referred to as pocket peripheral surface) is smaller than a predetermined angle, when the susceptor which warps to be in an inverted U shape in longitudinal sectional view is used, the inclination of the substrate supporting surface with respect to the pocket peripheral surface is offset by this warp, so that the inclination angle with respect to the horizontal surface becomes 0 degree or less. Thus, the rear surface of the semiconductor substrate may contact the inner peripheral edge of the substrate supporting surface, thereby making an arc shaped scratch prone to be generated on the rear surface of the semiconductor substrate. Specifically, for example, in a case of a pocket for a silicon single crystal substrate of 300mm in diameter, when the inclination angle of the substrate supporting surface with respect to the pocket peripheral surface is smaller than 0.2 degrees, and the susceptor warps to be in an inverted U shape to have a warp amount of not less than 0.3mm, an arc shaped scratch is generated on the rear surface of the silicon single crystal substrate. The warp amount of the susceptor means a difference of elevation of a central portion and an outer peripheral portion of the rear surface of the susceptor.

According to the present invention, the substrate supporting surface of the outer peripheral side pocket portion is inclined with respect to the horizontal surface to be lowered toward the central side from the outer peripheral side of the pocket, and a region of the substrate supporting surface excluding at least the inner peripheral edge supports a portion of the rear surface of the semiconductor substrate which is inside the outer peripheral edge of the semiconductor substrate. Thus, even when the semiconductor substrate warps due to heat stress, unlike the conventional technique, vapor phase growth of a single crystal substrate can be performed on the front surface of the semiconductor substrate without generating a scratch on the rear surface thereof by the inner peripheral edge of the substrate supporting surface of the susceptor. Moreover, the substrate supporting surface does not support the semiconductor substrate only at the outer peripheral edge of the semiconductor substrate, so that it is possible to suppress occurrence of slip dislocation of the single crystal thin film which is subjected to vapor phase growth.

In the susceptor of the present invention, preferably, the substrate supporting surface is inclined with respect to the horizontal surface at an angle equal to an angle which is made by the horizontal surface and a tangent to the semiconductor substrate at a contact of the substrate supporting surface and the semiconductor substrate in an imaginary plane including an central axis of the pocket. In this case, even when the semiconductor substrate warps due to heat stress, it is certainly prevented that the substrate supporting surface supports the semiconductor substrate only at the outer peripheral edge of the semiconductor substrate. Accordingly, occurrence of slip dislocation of the single crystal thin film to be formed can certainly be prevented.

In the susceptor of the present invention, preferably, the central side pocket portion is concave to have a depth so as not to contact a rear surface of the semiconductor substrate. In this case, the central side pocket portion and the rear surface of the semiconductor substrate do not rub each other, so that generation of a scratch on the rear surface of the semiconductor substrate can certainly be prevented.

In accordance with the second aspect of the present invention, the vapor phase growth apparatus of the present invention comprises: the susceptor of the present invention.

### Brief Description of The Drawings

FIG. 1 is a longitudinal sectional view showing a schematic structure of an embodiment of a vapor phase growth apparatus according to the present invention,
FIG. 2A is a longitudinal sectional view of a susceptor according to the present invention,
FIG. 2B is a plan view showing a rear surface of the susceptor,
FIG. 3 is an enlarged view of a part shown with a circle in FIG. 2A, and
FIG. 4 is a longitudinal sectional view showing a conventional susceptor.

### Best Mode for Carrying Out the Invention

An embodiment of a vapor phase growth apparatus according to the present invention will be explained below referring to the drawings. The vapor phase growth apparatus of the embodiment is a single wafer type vapor phase growth apparatus for performing vapor phase growth of a single crystal thin film on a front surface of a semiconductor substrate.

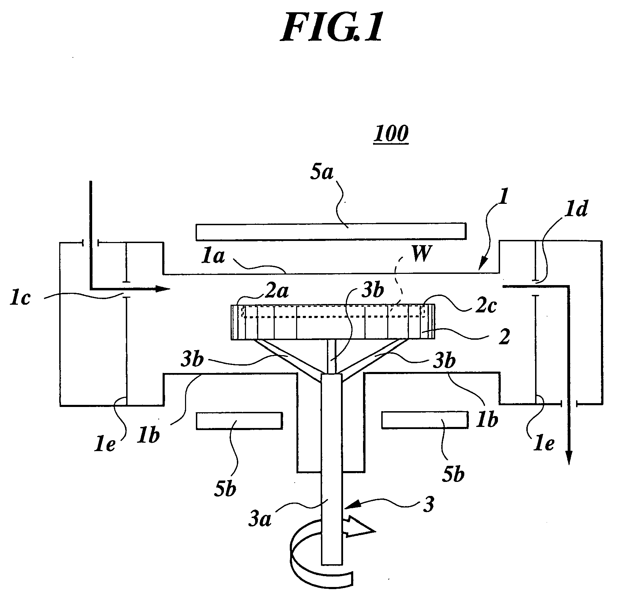

FIG. 1 is a longitudinal sectional view showing a schematic structure of a vapor phase growth apparatus 100. The vapor phase growth apparatus 100 is a single wafer type vapor phase growth apparatus, and comprises a reactor 1 in which a semiconductor substrate W such as a silicon single crystal substrate or the like is placed.

The reactor 1 is a reaction chamber having a top wall 1a, a bottom wall 1b and a side wall 1e. The top wall 1a and the bottom wall 1b are formed from quartz with translucency. A gas supply opening 1c for supplying a reaction gas for vapor phase growth into the reactor 1 and a gas exhaust opening 1d for exhausting the reaction gas from the reactor 1 are formed in the side wall 1e. The gas supply opening 1c is connected with a gas supplying device (not shown) for supplying the reaction gas with a predetermined composition and flow. For example, when performing vapor phase growth of a silicon single crystal thin film on a silicon single crystal substrate, the reaction gas preferably used is a mixed gas of a SiHCl₃ gas (trichlorosilane) which is a material gas and a H₂ gas which is a carrier gas.

A heating device 5a for radiating heat toward the inside of the reactor 1 through the top wall 1a is arranged above the reactor 1, and a heating device 5b for radiating heat toward the inside of the reactor 1 through the bottom wall 1b is arranged below the reactor 1. In this embodiment, a halogen lamp is used as the heating device 5a and the heating device 5b.

An approximately disk shaped susceptor 2 for placing the semiconductor substrate W is arranged in the reactor 1 in a state of being supported by a support member 3.

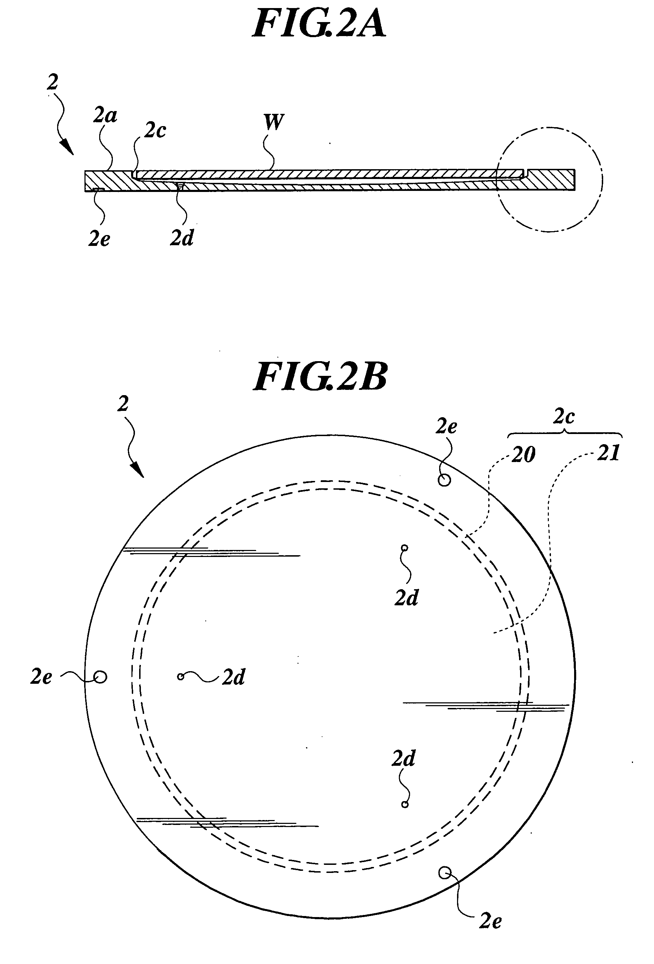

The susceptor 2 is formed by coating graphite with silicon carbide (SiC). As shown in FIG. 2A, a front surface of the susceptor 2, that is, an upper surface of the susceptor 2 has an approximately round shaped pocket 2c for horizontally supporting the semiconductor substrate W from below and a peripheral surface 2a of the pocket 2c (hereinafter, referred to as a pocket peripheral surface).

More specifically, as shown in FIG. 2B and FIG. 3, the pocket 2c has an outer peripheral side pocket portion 20 for supporting the semiconductor substrate W and a central side pocket portion 21 which is formed inside the outer peripheral side pocket portion 20 to be concave from the outer peripheral side pocket portion 20.

The outer peripheral side pocket portion 20 has a substrate supporting surface 20a. As shown in FIG. 3, the substrate supporting surface 20a is inclined to be lowered toward the central side from the outer peripheral side of the pocket 2c at an angle of more than 0 degree and 1 degree or less with respect to the horizontal surface. The outer peripheral side pocket portion 20 is configured such that a region of the substrate supporting surface 20a excluding at least an inner peripheral edge 20b, that is, a corner portion formed between the outer peripheral side pocket portion 20 and the central side pocket portion 21 supports a portion of the semiconductor substrate W which is inside the outer peripheral edge thereof. In an imaginary plane including a central axis of the pocket 2c, the angle made by the substrate supporting surface 20a and the horizontal surface is equal to the angle made by the horizontal surface and a tangent to the semiconductor substrate W which is bent into a U shape in longitudinal sectional view because of heat stress at the time of vapor phase growth, at the contact of the substrate supporting surface 20a and the semiconductor substrate W.

The central side pocket portion 21 is formed into a U shape in longitudinal sectional view, and is concave to have a depth so that the rear surface of the semiconductor substrate W does not contact the central side pocket portion 21 at the time of vapor phase growth. Although it is not shown in FIG. 3, the semiconductor substrate W placed in the pocket 2c is heated from above by the heating device 5a and also is heated from below through the susceptor 2 by the heating device 5b as shown in FIG. 1.

In the central side pocket portion 21 of the pocket 2c, as shown in FIG. 2B, three through holes 2d are formed along a peripheral direction of the susceptor 2 with a predetermined interval to penetrate from front to rear of the susceptor 2. The through holes 2d are holes for making lift pins (not shown) for moving up and down the semiconductor substrate W pass therethrough.

At a portion outside of the pocket 2c, three recess portions 2e are provided open on the rear surface of the susceptor 2 to be adjacent to the through holes 2d along radial direction, respectively.

As shown in FIG. 1, the support member 3 comprises a rotary shaft 3a extending in a vertical direction below the susceptor 2. At a top end portion of the rotary shaft 3a, there are provided three spokes 3b radially branching in an obliquely upward direction. A tip portion of each spoke 3b engages the recess portion 2e of the susceptor 2 to support the susceptor 2. Connected to the rotary shaft 3a is a rotary driving section (not shown), and the susceptor 2 is rotated by driving the rotary driving section.

Next, an explanation will be made of a procedure in a case of performing vapor phase growth of a silicon single crystal thin film on a silicon single crystal substrate of 300mm in diameter by using the above described vapor phase growth apparatus 100.

First, a silicon single crystal substrate is conveyed to be placed in the pocket 2c of the susceptor 2.

Next, the silicon single crystal substrate is heated by the heating devices 5a, 5b, and the susceptor 2 is rotated by the above described rotary driving section. In this state, a mixing gas of a SiHCl₃ gas and a H₂ gas is supplied into the reactor 1 from the gas supply opening 1c to perform vapor phase growth.

While performing vapor phase growth, the silicon single crystal substrate is bent into a U shape in longitudinal sectional view. On the other hand, the substrate supporting surface 20a of the susceptor 2 is adapted to incline to be lowered toward the central side from the outer peripheral side of the pocket 2c, so that a region of the substrate supporting surface 20a excluding at least the inner peripheral edge 20b supports a portion of the rear surface of the silicon single crystal substrate which is inside the outer peripheral edge thereof. At this time, in an imaginary plane including a central axis of the pocket 2c, the angle made by the substrate supporting surface 20a and the horizontal surface is equal to the angle made by the horizontal surface and a tangent to the silicon single crystal substrate which is bent at the contact of the silicon single crystal substrate and the substrate supporting surface 20a. With this structure, it can be certainly prevented that the substrate supporting surface supports the semiconductor substrate only at the outer peripheral edge of the semiconductor substrate, and that the rear surface of the silicon single crystal substrate contacts the inner peripheral edge of the substrate supporting surface.

According to the above vapor phase growth apparatus 100, the rear surface of the silicon single crystal substrate can be supported without generating an arc shaped scratch on the rear surface of the silicon single crystal substrate, and also vapor phase growth of the silicon single crystal thin film can be performed on the front surface of the silicon single crystal substrate while suppressing occurrence of slip dislocation.

The substrate supporting surface 20a of the susceptor 2 is inclined at an angle of not more than 1 degree with respect to the horizontal surface, so that the silicon single crystal substrate is not supported only at the outer peripheral edge of the silicon single crystal substrate, thereby enabling to suppress occurrence of slip dislocation of the silicon single crystal thin film which is subjected to vapor phase growth.

The central side pocket portion 21 of the pocket 2c is formed not to contact the rear surface of the silicon single crystal substrate, so that the central side pocket portion 21 of the pocket 2c and the rear surface of the silicon single crystal substrate do not rub each other. Accordingly, in a case that a scratch on the rear surface is easily generated such as when the silicon single crystal substrate is subjected to a mirror finished on the rear surface thereof or the like, generation of a scratch can be suppressed.

In the above embodiment, the explanation was made in which the vapor phase growth apparatus 100 is a single wafer type vapor phase growth apparatus, however, for example, a pancake type vapor phase growth apparatus may be used as long as the apparatus can support the semiconductor substrate W in a pocket approximately horizontally.

Moreover, the explanation was made in which the substrate supporting surface 20a is inclined with respect to the horizontal surface to be lowered toward the central side from the outer peripheral side of the pocket 2c. It is preferable that the inclination angle of the substrate supporting surface 20a with respect to the pocket peripheral surface 2a be not less than 0.2 degrees. In this case, even when using the susceptor 2 which warps to be an inverted U shape in longitudinal sectional view, if the warp amount of the susceptor 2 is not more than 0.3mm, the inclination of the substrate supporting surface 20a is not offset by this warp. Accordingly, even when using the susceptor 2 which warps to be an inverted U shape, vapor phase growth of the silicon single crystal thin film can be performed on the front surface of the silicon single crystal substrate without making an arc shaped scratch on the rear surface thereof.

As above, in the embodiment of the present invention, the vapor phase growth apparatus 100 for performing vapor phase growth of the single crystal thin film on the front surface of the semiconductor substrate W comprises the disk shaped susceptor 2 for horizontally supporting the semiconductor substrate W in the pocket 2c from below. The pocket 2c comprises the outer peripheral side pocket portion 20 having the substrate supporting surface 20a which supports the semiconductor substrate W and the central side pocket portion 21 which is formed to be concave from the outer peripheral side pocket portion 20. The outer peripheral side pocket portion 20 comprises the substrate supporting surface 20a which is inclined with respect to the horizontal surface to be lowered toward the central side from the outer peripheral side of the pocket 2c, and supports a portion of the rear surface of the semiconductor substrate W which is inside the outer peripheral edge thereof by the region of the substrate supporting surface 20a excluding at least the inner peripheral side pocket portion 20b. The central side pocket portion 21 of the pocket 2c is concave to have a depth so as not to contact the rear surface of the semiconductor substrate W.

### Industrial Applicability

According to the susceptor and the vapor phase growth apparatus of the present invention, even when a semiconductor substrate warps, vapor phase growth of a single crystal thin film can be performed on a front surface of the semiconductor substrate without making an arc shaped scratch on a rear surface of the semiconductor substrate by the inner peripheral edge of the substrate supporting surface of the pocket. Moreover, the substrate supporting surface does not support the semiconductor substrate only at an outer peripheral edge of the semiconductor substrate, so that occurrence of a slip dislocation of the single crystal thin film which is subjected to vapor phase growth can be suppressed. Accordingly, the susceptor and the vapor phase growth apparatus of the present invention are suitable for the case of suppressing generation of a scratch.

## Claims

1. A susceptor in which a semiconductor substrate is supported approximately horizontally in a pocket when performing a vapor phase growth of a single crystal thin film on a front surface of the semiconductor substrate, and in which the pocket comprises an outer peripheral pocket portion to support the semiconductor substrate and a central side pocket portion which is formed inside the outer peripheral side pocket portion to be concave from the outer peripheral side pocket portion,
wherein the outer peripheral side pocket portion comprises a substrate supporting surface which is inclined with respect to a horizontal surface to be lowered toward a central side from an outer peripheral side of the pocket, and a region of the substrate supporting surface excluding at least an inner peripheral edge supports a portion of a rear surface of the semiconductor substrate which is inside an outer peripheral edge of the semiconductor substrate.

2. The susceptor of claim 1, wherein the pocket is for a silicon single crystal substrate of 300mm in diameter, and the substrate supporting surface is inclined at an angle of more than 0 degree and not more than 1 degree with respect to the horizontal surface.

3. The susceptor of claim 1 or 2, wherein the substrate supporting surface is inclined with respect to the horizontal surface at an angle equal to an angle which is made by the horizontal surface and a tangent to the semiconductor substrate at a contact of the substrate supporting surface and the semiconductor substrate in an imaginary plane including an central axis of the pocket.

4. The susceptor of any one of claims 1 to 3, wherein the central side pocket portion is concave to have a depth so as not to contact a rear surface of the semiconductor substrate.

5. A vapor phase growth apparatus comprising:
the susceptor of any one of claims 1 to 4.
